(19) Europäisches Patentamt
European Patent Office
Office européen des brevets

(11) **EP 1 480 082 B1**

(12) **EUROPÄISCHE PATENTSCHRIFT**

(45) Veröffentlichungstag und Bekanntmachung des Hinweises auf die Patenterteilung:
**30.11.2005 Patentblatt 2005/48**

(51) Int Cl.⁷: **G03F 7/20**, G02B 17/06

(21) Anmeldenummer: **04018664.5**

(22) Anmeldetag: **27.05.1999**

(54) **Ringfeld-4-Spiegelsysteme mit konvexem Primärspiegel für die EUV-Lithographie**

Ringfield four mirror system with convex primary mirror for EUV lithography

Système de quatre miroirs à champ annulaire pour lithographie EUV

(84) Benannte Vertragsstaaten:
**DE FR GB IE IT NL**

(30) Priorität: **30.05.1998 DE 19824442**

(43) Veröffentlichungstag der Anmeldung:
**24.11.2004 Patentblatt 2004/48**

(62) Dokumentnummer(n) der früheren Anmeldung(en) nach Art. 76 EPÜ:
**99110265.8 / 0 962 830**

(73) Patentinhaber: **Carl Zeiss SMT AG**
**73447 Oberkochen (DE)**

(72) Erfinder: **Dinger, Udo**
**73447 Oberkochen (DE)**

(74) Vertreter: **Sawodny, Michael-Wolfgang**
**Adolf - Lüken - Höflich - Sawodny,**
**Dreiköniggasse 10**
**89073 Ulm (DE)**

(56) Entgegenhaltungen:
EP-A- 0 422 853 EP-A- 0 480 617
US-A- 5 063 586 US-A- 5 153 898
US-A- 5 315 629

- SWEENEY D W ET AL: "EUV optical design for a 100 nm CD imaging system" EMERGING LITHOGRAPHIC TECHNOLOGIES II, SANTA CLARA, CA, USA, 23-25 FEB. 1998, Bd. 3331, 25. Februar 1988 (1988-02-25), Seiten 2-10, XP002112300 Proceedings of the SPIE - The International Society for Optical Engineering, 1998, SPIE-Int. Soc. Opt. Eng, USA ISSN: 0277-786X
- JEWELL T E ET AL: "REFLECTIVE SYSTEMS DESIGN STUDY FOR SOFT X-RAY PROJECTION LITHOGRAPHY" JOURNAL OF VACUUM SCIENCE AND TECHNOLOGY: PART B, Bd. 8, Nr. 6, 1. November 1990 (1990-11-01), Seiten 1519-1523, XP000169155 ISSN: 0734-211X
- JEWELL T E: "Optical system design issues in development of projection camera for EUV lithography" ELECTRON-BEAM, X-RAY, EUV, AND ION-BEAM SUBMICROMETER LITHOGRAPHIES FOR MANUFACTURING V, SANTA CLARA, CA, USA, 20-21 FEB. 1995, Bd. 2437, 21. Februar 1995 (1995-02-21), Seiten 340-346, XP002112301 Proceedings of the SPIE - The International Society for Optical Engineering, 1995, USA ISSN: 0277-786X
- PATENT ABSTRACTS OF JAPAN Bd. 096, Nr. 002, 29. Februar 1996 (1996-02-29) & JP 07 283116 A (NIKON CORP), 27. Oktober 1995 (1995-10-27)

**Beschreibung**

Die Erfindung betrifft ein Reduktionsobjektiv gemäß dem Oberbegriff von Anspruch 1, eine Belichtungsanlage gemäß Ansprüche 11 und 12 sowie ein Chipherstellungsverfahren gemäß Anspruch 13.

Die Lithographie mit Wellenlängen < 193 nm, insbesondere die EUV-Lithographie mit $\lambda$ = 11 nm bzw. $\lambda$ = 13 nm werden als mögliche Techniken zur Abbildungen von Strukturen < 130 nm, besonders bevorzugt < 100 nm diskutiert. Die Auflösung eines lithographischen Systems wird durch nachfolgende Gleichung beschrieben:

$$RES = k_1 \cdot \frac{\lambda}{NA}$$

wobei k1 ein spezifischer Parameter des Lithographieprozesses, $\lambda$ die Wellenlänge des einfallenden Lichtes und NA die bildseitige, numerische Apertur des Systems bezeichnet.

Für abbildende Systeme im EUV-Bereich stehen als optische Komponenten im wesentlichen reflektive Systeme mit Multilayer-Schichten zur Verfügung. Als Multilayer-Schichtsysteme finden bei $\lambda$ = 11 nm bevorzugt Mo/Be-Systeme und bei $\lambda$ = 13 nm Mo/Si-Systeme Verwendung.

Legt man eine eine numerische Apertur von 0,10 zugrunde, so erfordert die Abbildung von 100 nm-Strukturen mit 13 nm-Strahlung einen Prozeß mit $k_1$ = 0,77. Mit $k_1$ = 0,64 wird bei 11 nm-Strahlung die Abbildung von 70 nm-Strukturen möglich.

Da die Reflektivität der eingesetzten Multirayer-Schichten nur im Bereich von ungefähr 70 % liegt, ist es bei den Projektionsobjektiven für die EUV-Mikrolithographie von ganz entscheidender Bedeutung, zum Erreichen einer ausreichenden Lichtstärke mit möglichst wenig optischen Komponenten im EUV-Projektionsobjektiv auszukommen.

Besonders bevorzugt haben sich mit Blick auf eine hohe Lichtintensität und ausreichende Möglichkeiten zur Korrektur von Abbildungsfehlern bei NA = 0,10 Systeme mit vier Spiegeln herausgestellt.

Weitere Anforderungen an ein EUV-Projektionobjektiv für die EUV-Lithographie betreffen Obskurationen, Bildfeld, Verzeichnung, bild- und objektseitige Telezentrie, den freien Arbeitsabstand sowie die Blende.

Obskurationen, z. B. Mittenabschattungen wie in Schwarzschildsystemen, sind nicht zulässig, da es sonst zu intolerablen Degradationen der Abbildungsgüte kommt.

Fordert man einen obskurationsfreien Strahlengang so resultiert bei zentrierten Systemen ein außeraxiales Bildfeld. Um Bildformate von 26x34mm$^2$ bzw. 26x52mm$^2$ bereitzustellen, ist es vorteilhaft die Systeme als Ringfeldscanner auszubilden. Die nutzbare Sekantenlänge des Scanschlitzes beträgt dann mindestens 26mm. Die Ringbreite sollte um eine homogene Beleuchtung bzw. Belichtungs-Kontrolle und 'Dose-Control' zu ermöglichen im Bereich 0,5 - 2 mm liegen.

Bei der Verzeichnung unterscheidet man zwischen statischer und dynamischer oder Scan-Verzeichnung. Die Scanverzeichnung ist die effektive, sich durch Integration der statischen Verzeichnung über den Scanweg ergebende Verzeichnung. Grenzen für die maßstabskorrigierte, statische Verzeichnung ergeben sich im wesentlichen aus den Spezifikationen für Kontrast und CD-Variation.

Es ist bildseitige Telezentrie erforderlich. Handelt es sich bei dem Projektionssystem um ein System mit einer Reflektionsmaske, so ist ein telezentrischer Strahlengang objektseitig nicht möglich. Werden Transmissionsmasken, z. B. Stencilmasken, eingesetzt ist auch ein telezentrischer Strahlengang realisierbar.

Um saubere Bündelbegrenzungen zu ermöglichen ist es vorteilhaft, wenn die Blende physikalisch zugänglich ist.

Die bildseitige Telezentrieforderung bedeutet, daß die Eintrittspupille des letzten Spiegels in oder nahe seines Brennpunktes, zu liegen kommt. Um ein kompaktes Design bei zugänglicher Blende zu erhalten, bietet es sich an, den vorletzten Spiegel als bündelbegrenzendes Element dort zu plazieren.

Aus nachfolgenden Veröffentlichungen sind 4-Spiegel-Projektions- bzw. Reduktionsobjektive bekanntgeworden:

* US 5 315 629
* EP 0 480 617
* US 5 063 586
* EP 0 422 853
* Donald W. Sweeney, Russ Hudyma, Henry N.Chapman, David Shafer, EUV optical Design for a 100 mm CD Imaging System, 23rd International Symposium of microlithography, SPIE, Santa Clara, California, February 22-27,1998, SPIE Vol. 3331, p. 2ff.

In der US 5 315 629 wird ein 4-Spiegel-Projektionsobjektiv mit NA = 0,1, 4x, 31.25x0,5mm$^2$ beansprucht. Die Spiegelfolge ist konkav, konvex, konkav, konkav.

Aus der EP 0 480 617 B1 sind zwei NA=0.1, 5x, 25x2mm$^2$-Systeme bekanntgeworden. Die Spiegelfolge ist konkav, konvex, beliebig / konvex, konkav.

Die Systeme gemäß US 5 063 586 und EP 0 422 853 weisen ein rechteckiges Bildfeld, von beispielsweise mindestens 5x5mm$^2$, auf. Die im allgemeinen dezentrierten Systeme sind mit sehr hohen Verzeichnungswerten im %-Bereich behaftet. Die Objektive könnten daher nur in Steppem mit Verzeichnungsvorhalt auf dem Retikel eingesetzt werden. Das hohe Niveau der Verzeichnung macht derartige Objektive allerdings bei den hier diskutierten Strukturbreiten ($\leq$ 130 nm) unpraktikabel. Die Spiegelfolge ist konvex, konkav, konvex, konkav.

Aus der US 5 153 898 sind pauschal beliebige 3 bis 5-Multilayer-SpiegelSysteme bekanntgeworden. Die offengelegten Realisierungen beschreiben allerdings durchweg 3-Spiegelsysteme mit Rechteckfeld und kleiner numerischer Apertur NA (NA<0.04). Die Systeme sind daher auf die Abbildung von Strukturen >=0.25$\mu$m beschränkt.

Betreffend den allgemeinen Stand der Technik wird des weiteren auf T. Jewell: "Optical system design issues in development of projection camera for EUV lithography", Proc.SPIE 2437 (1995) und die darin angegebenen Zitate verwiesen.

Es hat sich bei den bekannten Systemen gemäß der EP 0 480 617 sowie US 5 315 629 und gemäß Sweeney a.a.O. als nachteilig erwiesen, daß der außeraxial genutzte Teil des Primärspiegels mechanisch mit den waferseitigen Sensoraufbauten einer Projektionsbelichtüngsanlage in Konflikt gerät, wenn nicht sehr große freie mechanische Arbeitsabstände > 100 mm realisiert werden. Diese Konflikte treten bei Spiegelsegmenten, die "bildfeldnah" plaziert sind, erst bei wesentlich geringeren Abständen ($\approx$10 mm) auf.

Aufgabe der Erfindung ist es, somit eine für die Lithographie mit kurzen Wellenlängen, $\leq$ 193 nm, vorzugweise < 100 nm, geeignete Projektionsobjektiveinrichtung anzugeben, die die zuvor erwähnten Nachteile des Standes der Technik nicht aufweist, mit möglichst wenigen optischen Elementen auskommt und andererseits eine ausreichend große Apertur aufweist und die Telezentrieanforderungen sowie sämtliche weitere Anforderung an ein Projektionssystem für Wellenlängen $\leq$ 193 nm erfüllen.

Erfindungsgemäß wird die Aufgabe durch ein Projektionsobjektiv gelöst, das vier Spiegel umfaßt und durch einen konvexen Primärspiegel sowie eine positive Hauptstrahlwinkelvergrößerung des Sekundärspiegels gekennzeichnet ist.

Durch die Ausbildung als 4-Spiegel-System werden hohe Transmission bei Wellenlängen im EUV-Bereich erreicht, wenn man eine Reaktivität der Mehrfachschichtsysteme für diese Strahlung mit 70% zugrundelegt. Andererseits können Aperturen im Bereich NA$\approx$0,10 realisiert werden. Das 4-Spiegel-Objektiv gemäß der Erfindung zeichnet sich somit durch hohe Auflösung, niedrige Fertigungskosten und hohen Durchsatz aus.

In einer bevorzugten Ausgestaltung der Erfindung ist vorgesehen, daß die Blende auf oder nahe einem Spiegel liegt, insbesondere dem Tertiärspiegel. Die Blende ist dann physikalisch zugänglich, das Design kompakt und abschattungsfrei. Vorteilhafterweise sind zusätzlich zu den vier Spiegeln ein oder zwei Spiegel in streifendem Einfall angeordnet, wobei der oder die zusätzlichen Spiegel bevorzugt von einer Planfläche abgeleitete asphärische Flächen aufweisen können.

Vorteilhafterweise ist mindestens ein Spiegel ein aktiver Spiegel.
In einer Ausführungsform eines 4-Spiegel-Objektives sind der Sekundärspiegel und der Quartärspiegel konkav.

Vorteilhafterweise sind die Multilayer-Spiegel in der Reihenfolge konvex-konkav-konvex-konkav ausgebildet.

Die in dieser Schrift diskutierten Asphärizitäten beziehen sich auf die Spitze-Spitze- bzw. peak to valley (PV) -Abweichung A der asphärischen Flächen gegenüber der im Nutzbereich bestpassenden Sphäre.

Diese werden in den Beispielen durch eine Sphäre approximiert, deren Mittelpunkt auf der Figurenachse des Spiegels liegt und die im Meridionalschnitt die Ashpäre im oberen und unteren Endpunkt des Nutzbereiches schneidet.

Die Angaben zu den Einfallswinkeln beziehen sich jeweils auf den Winkel zwischen jeweiligen einfallendem Strahl und Flächennormale am Einfällsort. Angegeben ist jeweils der größte Winkel irgendeines Strahles, im allgemeinen eines bündelbegrenzenden Strahles, der an irgendeinem der Spiegel auftritt.

Besonders bevorzugt beträgt der waferseitige optische freie Arbeitsabstand 60 mm. Der retikelseitige freie Arbeitsabstand beträgt mindestens 100 mm.

Die zuvor beschriebenen Objektive können nicht nur für die EUV-Lithographie eingesetzt werden, sondern selbstverständlich auch bei anderen Wellenlängen, ohne daß von der Erfindung abgewichen wird. Praktisch wird das nur bei UV-Wellenlängen im Bereich um 193 nm bei Excimer-Lasern in Betracht kommen.

Um eine beugungsbegrenzte Abbildung zu erreichen, ist mit Vorteil vorgesehen, daß der Design-Anteil des rms-Wellenfrontanteils des Systems höchstens 0,07 $\lambda$, bevorzugt 0,03 $\lambda$ beträgt.

Vorteilhafterweise sind in den Beispielen der Erfindung die Objektive stets bildseitig telezentrisch ausgebildet.

Bei Projektionssystemen, die mit einer Reflektionsmaske betrieben werden, ist ein telezentrischer Strahlengang ohne Beleuchtung über einen stark transmissionsmindemden Strahlteiler, wie beispielsweise aus der JP-A-95/28 31 16 bekannt, objektseitig nicht möglich. Daher sind die Hauptstrahlwinkel am Retikel so gewählt, daß eine abschattungsfreie Beleuchtung gewährleistet ist.

Bei Systemen mit Transmissionsmaske kann vorgesehen sein, daß das Projektionsobjektiv objektseitig telezentrisch ausgelegt ist.

Im gesamten sollte der Telezentriefehler am Wafer 10 mrad nicht überschreiten, vorzugsweise liegt er bei 5 mrad, besonders bevorzugt bei 2 mrad. Dies stellt sicher, daß sich die Änderung des Abbildungsmaßstabes bzw. der Verzeichnung über den Tiefenschärfenbereich in tolerierbaren Grenzen hält.

Neben der erfindungsgemäßen Reduktions- bzw. Projektionsobjektiveinrichtung stellt die Erfindung auch eine Projektionsbelichtungsanlage, umfassend mindestens ein derartiges Objektiv , zur Verfügung. In einer ersten Ausführungsform weist die Projektionsbelichtungsanlage eine Reflektionsmaske auf, in einer alternativen Ausführungsform eine Transmissionsmaske.

Besonders bevorzugt ist es, wenn die Projektionsbelichtungsanlage eine Beleuchtungseinrichtung zur Beleuchtung eines außeraxialen Ringfeldes umfaßt und das System als Ringfeldsscanner ausgebildet ist. Mit Vorteil ist vorgesehen, daß die Sekantenlänge des Scan-Schlitzes mindestens 26 mm beträgt und die Ringbreite größer als 0,5 mm ist, so daß eine homogene Beleuchtung ermöglicht wird.

Mit dem erfindungsgemäßen Objektiv können des weiteren die asphärischen Abweichungen von der bestpassenden Sphäre gering gehalten werden, so daß die Forderung nach 'Beugungsbegrenztheit' und hoher Reflektivität der ML-Spiegel mit den hieraus folgenden extremen Genauigkeitsanforderungen an diese Oberflächen in allen Ortsfrequenbereichen vom freien Durchmesser der Spiegel bis zu atomaren Dimensionen eingehalten werden können.

Da die Refektivität der Spiegel im EUV-Bereich durch die Belegung der Substrate mit sog. DBRs (verteilte Bragg Reflektoren), auch als Multilayer bezeichnet, erreicht wird, bestehen diese bei $\lambda$ = 13nm und für Mo/Si-System aus ca. 40 Schichtpaaren, bei $\lambda$ = 11 nm aus ca. 70 Schichtpaaren.Die Winkelakzeptanz dieser Systeme liegt damit im Bereich weniger Grad und nimmt mit zunehmendem Einfallswinkel ab. Des weiteren nehmen mit zunehmendem Einfallswinkel auch störende, durch die Velfachstruktur verursachte Phaseneffekte, zu. Variiert der aufpunktbezogene mittlere Einfallswinkel zu stark über eine Systemfläche, so müssen Schichtpakete mit veränderlicher Dicke aufgebracht werden.

Da sich die erfindungsgemäßen Objektive durch einen geringeren mittleren Einfallswinkel und eine geringe flächenspezifische Variation um den mittleren Einfallswinkel auszeichnen, können die oben dargelegten Probleme von Multilayer-Systemen gering gehalten werden.

Die Erfindung soll nachfolgend anhand der Zeichnungen beispielhaft beschrieben werden.

Es zeigen:

Figur 1: schematische Darstellung, der in vorliegender Anmeldung verwendeten Systemklassifizierung.

Figur 2: Linsenschnitt eines ersten 4-Spiegel-Systems (Typ e_System) nach dem Stand der Technik

Figur 3: Linsenschnitt eines zweiten 4-Spiegel-Systems (Typ f_System)

Figur 4: Linsenschnitt eines dritten 4-Spiegel-Systems (Typ g_System)

Figur 5: ein 4-Spiegel-System vom Typ f mit eingefügtem grazing-incidence Spiegel

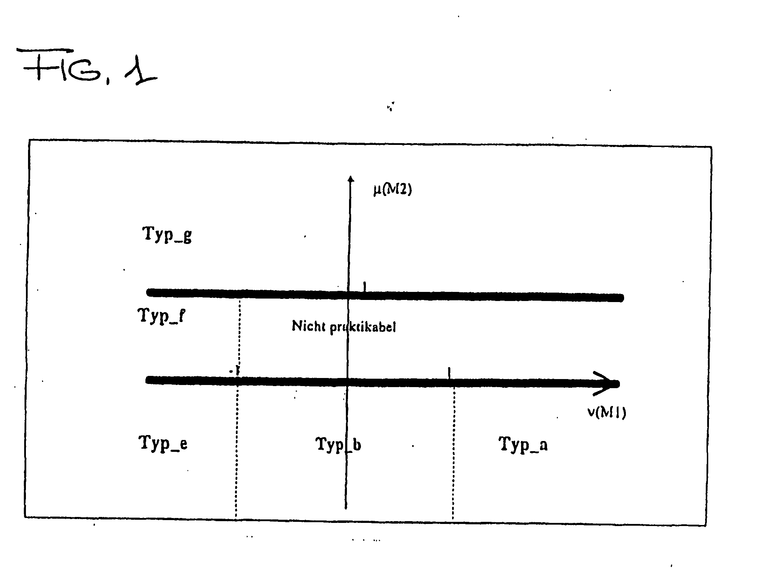

Bei den in Fig. 1-4 gezeigten Ausführungsbeispielen handelt es sich um zentrierte, bildseitig telezentrische Reduktionssysteme mit Blende auf dem dritten Spiegel M3. In sämtlichen Systemen werden für gleiche Bauelemente gleiche Bezugsziffem verwendet, wobei nachfolgende Nomenklatur verwendet wird:

- erster Spiegel (M1), zweiter Spiegel (M2)
- dritter Spiegel (M3), vierter Spiegel (M4)

Die verschiedenen Ausführungsformen lassen sich klassifizieren durch die Primärspiegelvergrößerung m (M1), bzw. durch das Konvergenzverhältnis v(M1)=-1/m(M1) und die Sekundärspiegel-Hauptstrahlwinkelvergrößerungen $\mu$(M2) Die Normenklatur erfolgt nach Dietrich Korsch, Reflective optics, Academic Press 1991, S. 41 ff:

|  | M1 | $\nu$(M1) | $\mu$(M2) |
|---|---|---|---|
| typ_a | konkav | $\in]1,\infty[$ | $<-\varepsilon_4$ |
| typ_b | plan, konkav | $\in[-1,1]$ | $<-\varepsilon_4$ |
| typ_e | konvex | $\in]-\infty,-1[$ | $<-\varepsilon_4$ |
| typ_f | konvex | $\in]-\infty,-1[$ | $\in]\varepsilon_4, 1-\varepsilon_2[$ |

(fortgesetzt)

|  | M1 | $\nu$(M1) | $\mu$(M2) |
|---|---|---|---|
| typ_g | konvex | $\in$]-∞,- 1[ | $\in$]1+$\varepsilon_3$, ∞[ |

Es gilt:

$\varepsilon_i$>0 wächst mit der numerischen Apertur NA des Systems, d. h.

$\varepsilon_i$=0 ==>NA=0

Eine schematische Darstellung der Systemklassifizierung wie nachfolgend verwendet, ist in Fig. 1 dargestellt.

Der Begriff Hauptstrahlwinkelvergrößerung bzw. angular magnification bezieht sich nicht auf den Winkel selbst, sondern auf dessen Tangens (siehe Korsch, Reflective optics a.a.O.) Positive Hauptstrahlwinkelvergrößerung bedeutet anschaulich, daß die Neigungen der mit den einfallenden und reflektierten Hauptstrahlen identifizierbaren Geraden bzgl. der optischen Achse gleiches Vorzeichen besitzen, bzw., daß die Eintritts- und Austrittspupillen des betreffenden Spiegels auf der physikalisch gleichen Seite des Spiegels liegen.

Wie aus Fig. 1 hervorgeht liegen die Typen a, b und e innerhalb eines topologisch zusammenhängenden Gebietes, d. h. die Systeme können innerhalb des Designparameterraumes kontinuierlich ineinander übergeführt werden.

Im Gegensatz hierzu ist dies nicht möglich für je zwei Systeme der Klassen (a, b, e), f und g, wenn Obskurationsfreiheit erfüllt sein soll. Die Balken in Fig.1 symbolisieren 'verbotene' Gebiete, in denen bei endlicher NA eine Abschattung der Lichtbündel durch Spiegel zwingend ist.

Die Zugehörigkeit zu dem jeweiligen topologischen Zusammenhangsgebiet wird durch $\mu$(M2) bestimmt. Die aus der US 531629 bzw. EP 0480617 bekannten Ringfeldsysteme gehören zur Kategorie Typ a. Typ b-Systeme vermitteln den kontinuierlichen Übergang zu den Typ_e Systemen, die auch das aus Donald W. Sweeney et. al., 23rd International Symposium of Microlithography a. a. O. bekannte System umfassen.

Systeme vom Typ f und Typ g sind aus keiner der angegebenen Veröffentlichungen bekannt. Gegenüber der US 5315629 bzw. EP 048 0617 unterscheiden sich die Systeme gemäß Typ f und Typ g durch den konvexen Primärspiegel. Das aus Donald W. Sweeney et. al. 23rd International Symposium of Microlithography a. a. O. bekannte System weist zwar einen konvexen Primärspiegel auf; hat jedoch eine andere Hauptstrahlwinkelvergrößerung an M2, und damit eine andere Strahlführung im System.

Systeme vom Typ f mit $\nu$(M1)>ca. -1,5 führen zu großen Hauptstrahlwinkeln am Retikel und großen Systemdurchmessem. Dadurch wird eine sinnvolle Systemauslegung mit konkavem M1 ($\nu$(M1)>-1) schwierig.

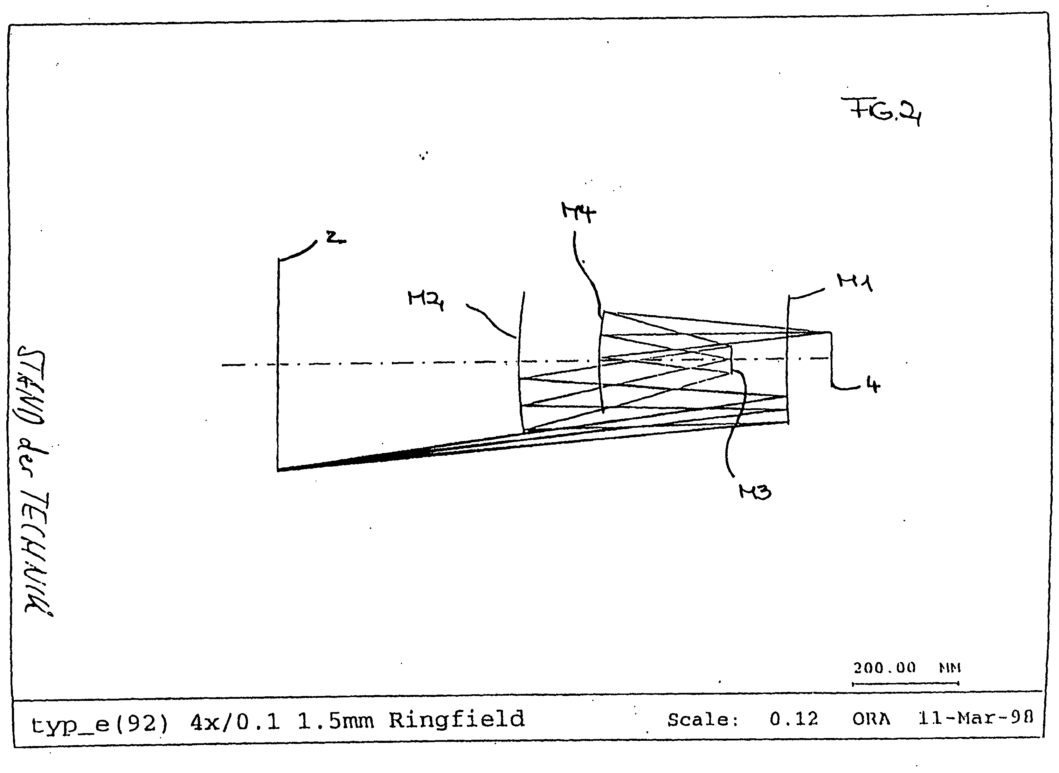

In der nachfolgenden Tabelle sind typische Funktionsdaten beispielhafter Ausführungsformen der verschiedenen Systemkategorien gegenübergestellt. Die Verzeichnungswerte ergeben sich nach Maßstabskorrektur über das Ringfeld. Beispielhafte Linsenschnitte der den einzelnen Systemklassen zugehörigen Systeme sind in den Fig. 2-5 gezeigt.

|  | Typ f (94) | Typ_g(68) |
|---|---|---|
| M1 | konvex | konvex |
| $\nu$(M1) | -2.4 | -2.9 |
| $\mu$(M2) | 0.6 | 1.6 |
| NA | 0.1 | 0.1 |
| Red | 4x | 4x |
| Ringfeld [mm$^2$] | 26.0x1.0 | 26.0x1.25 |
| mittl. Ringfeldradius [mm] | 25 | 51 |
| OO' [mm] | 1368 | 1112 |
| FWD [mm] | 92 | 62 |
| CRAO [mm] | $\in$[-2.1, -2.0] | $\in$[4.1,4.2] |
| CRA [mrad] | $\in$[-0.35,-0.50] | $\in$[-0.2,0.2] |
| max. Asph. [$\mu$m] | 19.6 | 8,3 |

(fortgesetzt)

| | Typ f (94) | Typ_g(68) |
|---|---|---|
| AOI max [deg] | 14.1 | 22.0 |
| $\Delta$AOI max [deg] | ±2.5 | ±2.8 |
| WFE max [$\lambda$rms] | 0.029 | 0.0025 |
| Verzeichnung [nmPV] | 7 | 30 |

| | Bedeutung |
|---|---|
| M1 | Form des Primärspiegel |
| $\nu$(M1) | 'convergence ratio' nach Korsch |
| $\mu$(M2) | 'angular magnification' nach Korsch |
| NA | bildseitige numerische Apertur |
| Red | Verkleinerungsfaktor=-1/Abbildungsmaßstab |
| Ringfeld [mm$^2$] | SekantenlängexRingbreite im Bildfeld |
| mittl. Ringfeldradius [mm] | Bildfeldradius in der Mitte des Ringfeldes |
| OO' [mm] | Objekt-Bild-Abstand |
| FWD [mm] | optisch freier Arbeitsabstand bildseitig |
| CRAO [deg] | Hauptstrahlwinkel im Objektraum |
| CRA [mrad] | Hauptstrahlwinkel im Bildraum |
| max. Asph. [$\mu$m] | max. Abweichung der Asphäre vom Hüllkreis über den Nutzbereich des Spiegels |
| AOI max. [deg] | maximaler Einfallswinkel |
| $\Delta$AOI max [deg] | Variation der Einfallswinkel über den Spiegel |
| WFE max [$\lambda$ rms] | maximaler rms-Wellenfrontfehler in Einheiten von $\lambda$ |
| Verzeichnung [nm PV] | Spitze-Spitze-Wert der über das Ringfeld maßstabskorrigierten Hauptstrahlverzeichnung |

Die Systeme mit konvexem M1 zeigen eine wesentlich höhere Asphärizität als die Typ_a-Ausführungen mit konkavem M1.
In Fig. 2 ist der Schnitt eines Typ e-Systems von der Retikelebene 2 bis zur Waferebene 4 gezeigt, wafemächster Spiegel ist der erste Spiegel M1.

Typ_e-Systeme haben die geringste Winkelbelastung auf den Spiegeln M1, M2, M3, M4 was die polarisationsoptischen Eigenschaften des Systems begünstigt. Die hohen Hauptstrahlwinkel an der Retikelebene 2 erfordern aber sehr ebene Retikel.

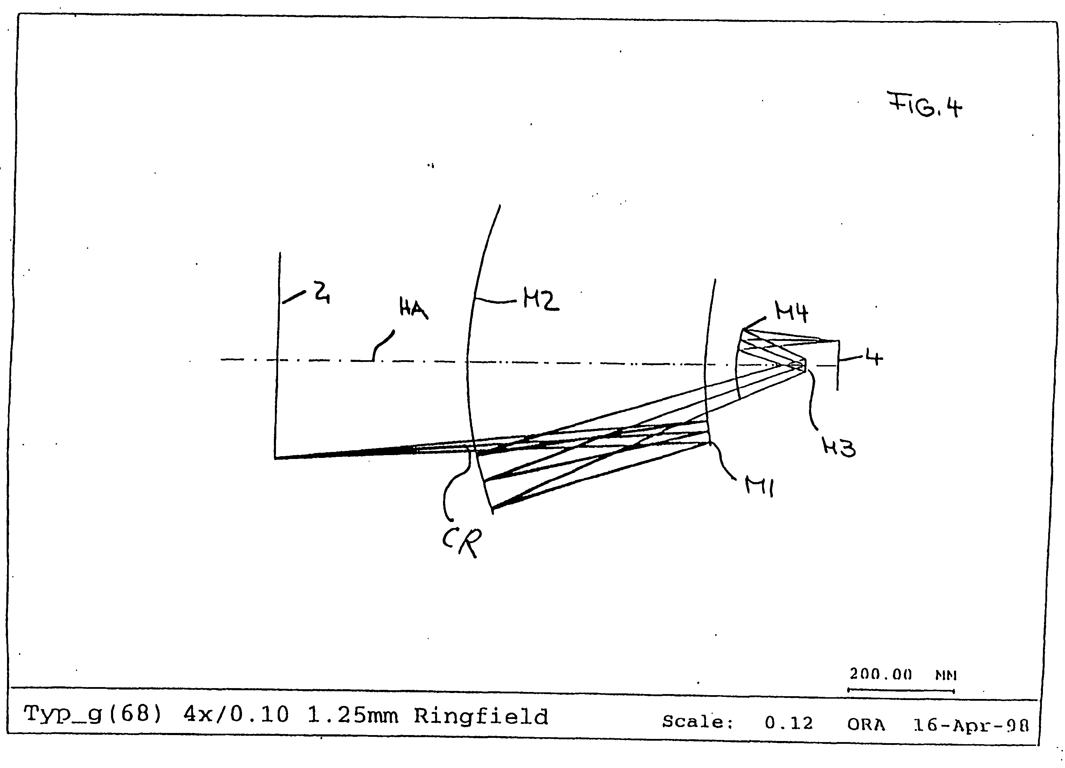

Umgekehrt zeigen Typ_g-Systeme, wie beispielhaft im Schnitt der Fig. 4 gezeigt, bei vertretbaren Hauptstrahlwinkeln am Retikel relativ große Winkelbelastungen auf den Spiegeln M1, M2, M3, M4.

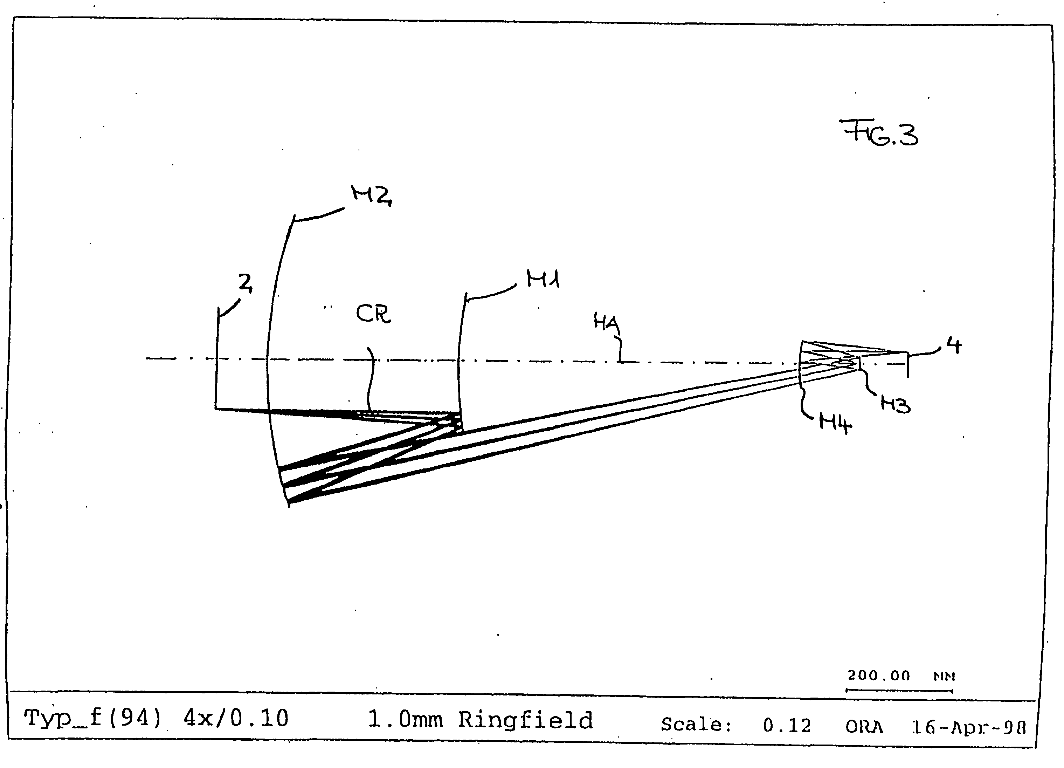

Typ_f-Systeme wie beispielhaft in Fig. 3 gezeigt, benötigen die stärksten Asphären, haben dafür aber günstige Winkelerteilungen auf den Spiegeln, M1, M2, M3, M4, und dem Retikel 2. Der sehr geringen Verzeichnung steht ein relativ kleines Bildfeld gegenüber. Die Baulänge ist zwar größer als bei den anderen Systemen, die lange Driftstrecke innerhalb des Objektives erlaubt andererseits ggf. das Einsetzen von Zusatzkomponenten, z. B. Alignmentsystem, Umlenkspiegel, etc.

Die Typ_f und Typ_g-Systeme, wie in den Fig. 3 und 4 gezeigt, können sowohl mit positiven, als auch mit negativen Hauptstrahlwinkeln am Retikel 2 realisiert werden. Damit kann eine optimale Geometrie, insbesondere ein vergleichsweise kleiner freier Arbeitsabstand zum Retikel 2, zur Einspiegelung des Lichtes bei Verwendung einer Reflexionsmaske gewählt werden. Bei Verwendung einer Transmissionsmaske läßt sich ein telezentrischer Strahlengang realisieren.

Die Systeme vom Typ_a und Typ_f besitzen relativ lange 'Driftstrecken' vor bzw. innerhalb des eigentlichen Spiegelsystems. Es ist möglich dort grazing-incidence-Spiegel hoher Reflektivität als Korrekturelemente, z. B. in der Art eines Schmidt-Korrektors oder eines aktiv optischen Korrektursystems einzufügen. Basierend auf den derzeitigen Literaturwerten ergibt sich für molybdänbeschichtete Spiegel bei 13,3 nm und 75° Einfallswinkel eine theoretisch mögliche Reflektivität von ca. 85% für unpolarisiertes Licht. Durch den streifenden Einfall der Bündel kann der ausgeleuchtete Querschnitt in einer Richtung - im Vergleich zu denjenigen auf den benachbarten Spiegeln - sehr groß gemacht werden, was die Auslegung der Korrekturelemente erleichtert. Die einzelnen Spiegel werden vorzugsweise paarweise mit aufeinander nahezu senkrecht stehenden Flächennormalen ausgestattet, um die Bündel in allen Raumrichtungen mit der gleichen Auflösung manipulieren zu können.

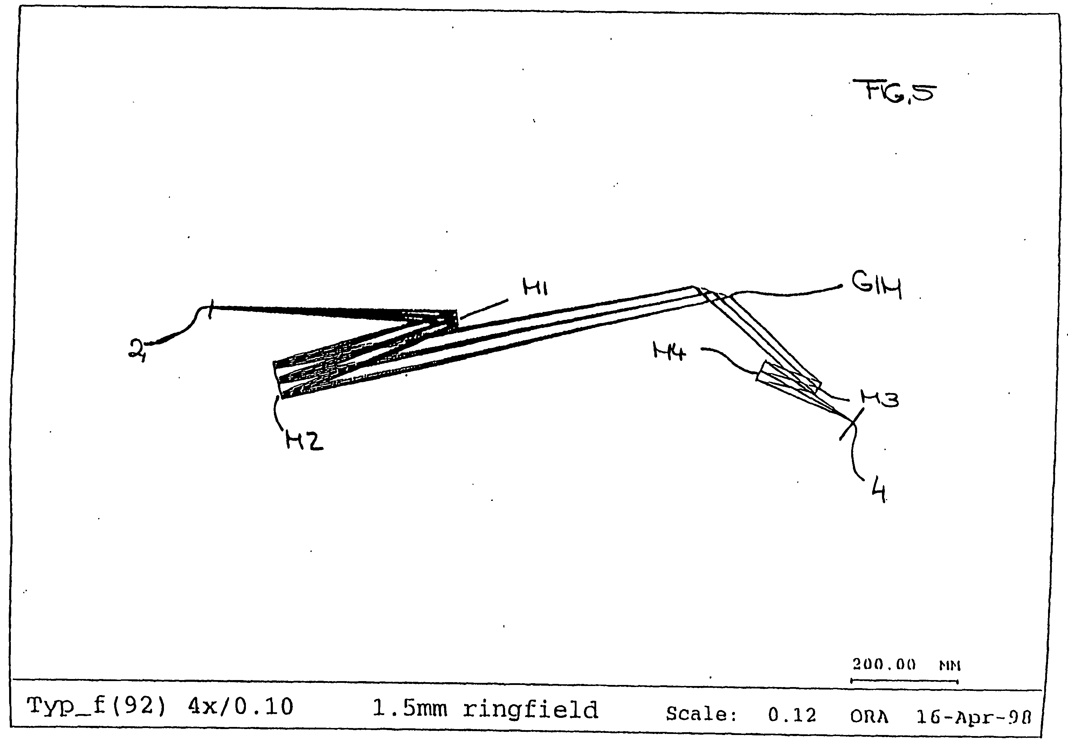

In Fig. 5 ist ein solches Design vom Typ_f mit eingefügtem grazing-incidence-Spiegel GIM dargestellt.

Aus nachfolgender Tabelle 1 gehen die Parameter des Systems gemäß Fig. 3 im Code V-Format hervor:

Tabelle 1:

| Typ_f(94) 4x/0.10 1.0mm Ringfeld | | | | |
|---|---|---|---|---|
| ELEMENT NUMMER | RADIUS | DICKE | DURCHMESSER | ART |
| | | | | |
| OBJEKT | INF | 0.000 | | |
| | | | 204.000 | |
| | | 100.228 | | |
| | | | 217.084 | |
| | | 380.421 | | |
| M1 | A(1) | -380.421 | 264.271 | REFL |
| M2 | A(2) | 380.421 | 563.054 | REFL |
| | | | 390.422 | |
| | | 796.185 | | |
| | | APERTUR-BLENDE | 23.764 | |
| M3 | A(3) | -117.968 | 23.764 | REFL |
| M4 | A(4) | 117.968 | 92.608 | REFL |
| | | | 71.790 | |
| | | 284.465 | | |
| | | | 89.622 | |
| BILD | BILDWETTE= | -192945 | | |
| | INF | | 50.989 | |

| Asphärische Konstanten: | | | | | | |
|---|---|---|---|---|---|---|
| $$Z = \frac{(CURV)\ Y^2}{1 + (1-(1+K)\ (CURV)^2\ Y^2)^{1/2}} + (A)\ Y^4 + (B)\ Y^6 + (C)\ Y^8 + (D)\ Y^{10}$$ | | | | | | |
| Asphare | CURV | K | A | B | C | D |
| A(1) | 0.0014137 | -4.643893 | 0.00000E-00 | -6.97355E-15 | 7.87388E-24 | 0.00000E+00 |
| A(2) | 0.0011339 | -0.232793 | 0.00000E+00 | -5.35926E-17 | 3.35875E-23 | 0.00000E+00 |
| A(3) | 0.0040246 | 3.006678 | 0.00000E-00 | 3.76117E-13 | -1.43488E-15 | 0.00000E+00 |
| A(4) | 0.0042162 | 0.289323 | 0.00000E+00 | 8.76473E-15 | 5.59142E-19 | 0.00000E+00 |
| Referenz Wellenlänge = 13 nm | | | | | | |

Die Konstruktionsdaten des in Fig. 4 dargestellten Typ g-Systems gehen aus nachfolgender Tabelle 2 hervor:

Tabelle 2:

| ELEMENT NUMMER | RADIUS | DICKE | DURCHMESSER | ART |
|---|---|---|---|---|
| OBJEKT | INF | 0.000 | | |
| | | | 413.000 | |
| | | 378.925 | | |
| | | | 373.642 | |
| | | 474.629 | | |
| M1 | A(1) | -474.629 | 327.612 | REFL |
| M2 | A(2) | 474.629 | 600.624 | REFL |
| | | | 206.075 | |
| | | 196.627 | | |
| | | APERTUR-BLENDE | 28.266 | |
| M3 | A(3) | -136.037 | 28.266 | REFL |
| M4 | A(4) | 136.037 | 141.438 | REFL |
| | | | 115.807 | |
| | | -196.627 | | |
| | | | 155.535 | |
| | | 160.000 | | |
| | | | 123.208 | |
| | BILDWEITE = | 98.781 | | |
| BILD | INF | | 103.302 | |

| ASPHÄRISCHE KONSTANTEN | CURV | K | A | B | C | D |
|---|---|---|---|---|---|---|
| A(1) | 0.0010894 | -0.738027 | 0.00000E+00 | 3.65218E-16 | -1.37411E-20 | 0.00000E+00 |
| A(2) | 0.0012023 | 0.031851 | 0.00000E+00 | 1.38321E.17 | -6.58953E-23 | 0.00000E+00 |
| A(3) | 0.0036931 | 1.579939 | 0.00000E+00 | -1.26703E-13 | 3.53973E-16 | 0.000000E+00 |
| A(4) | 0.0035917 | 0.316575 | 0.00000E+00 | 3.15582E-15 | 1.74158E-19 | 0.00000E+00 |
| REFERENZWELLEN-LANGE | 13.0 nm | | | | | |

Bringt man zwischen Spiegel M1, M2 und M3, M4 einen Umlenkspiegel, einen sog. grazing incidence Spiegel GIM ein, so erhält man den in Fig. 5 dargestellten Aufbau vom Typ f. Die Daten dieser Ausführungsform sind Tabelle 3 zu entnehmen.

Tabelle 3:

| Typ_f(xx) 4x/0.10 | 1.0mm Ringfeld | | | |
|---|---|---|---|---|
| ELEMENT NUMMER | RADIUS | DICKE | DURCHMESSER | ART |
| OBJEKT | INF | 0.000 | | |
| | | | 204.000 | |
| | | 100.000 | | |
| | | | 217.065 | |
| | | 380.407 | | |
| M1 | A(1) | -380.407 | 264.287 | REFL |
| M2 | A(2) | 380.407 | 563.152 | REFL |
| | | | 390.481 | |
| | | 296.123 | | |
| | DECENTER (1) | | | |
| GIM | INF | -499.995 | 536.341 | REFL |
| | | APERTUR-BLENDE | 23.757 | |
| M3 | A(3) | 117.968 | 23.757 | REFL |
| M4 | A(4) | -117.968 | 92.614 | REFL |
| | | | 69.580 | |
| | | -284.465 | | |
| | BILDWEITE= | 192.994 | | |
| BILD | INF | | 51.000 | |

| ASPHÄRISCHE KOONSTANTE | CURV | K | A | B | C | D |
|---|---|---|---|---|---|---|
| N | | | | | | |
| A(1) | 0.0014140 | -4.643296 | 0.00000E+00 | -6.99186-15 | 7.89877E-20 | 0.00000DE+00 |
| A(2) | 0.0011341 | -0.232835 | 0.0000DE-00 | -5.33514E-17 | 3.24688E-23 | 0.00000E+00 |
| A(3) | -0.0040253 | 3.007585 | 0.00000E+00 | -3.82589E-13 | 1.46212E-15 | 0.00000E+00 |
| A(4) | -0.0042169 | 0.289286 | 0.00000E+00 | -8.76770E-15 | 5.47269E-19 | 0.00000E+00 |
| DECENTER KONSTANTEN | | | | | | |
| DECENTER | | Umlenkwinkel ALPHA AM GIM | | | | |
| D(1) | | | | 75.00000 Grad | | |
| Wellenlänge 13 nm | | | | | | |

Mit der Erfindung wird somit erstmals ein 4-Spiegel-Projektionsobjektiv mit einem Abbildungsmaßstab von vorzugsweise 4x für den bevorzugten Einsatz in einem EUV-Ringfeldprojektionssystem angegeben, das sowohl die notwendige Auflösung bei gefordertem Bildfeld wie auch Konstruktionsbedingungen aufweist, welche eine funktionsgerechte Bauausführung ermöglichen, da die Asphären hinreichend mild, die Winkel hinreichend klein für die Schichten und die Bauräume für die Spiegelträger hinreichend groß sind.

**Patentansprüche**

1. Reduktionsobjektiv insbesondere der EUV-Mikrolithographie, mit

   - vier Spiegeln (M1, M2, M3, M4) in zentrierter Anordnung bezüglich einer optischen Achse, mit Primär-, Sekundär-, Tertiär-, Quartärspiegel in dieser Reihenfolge im Strahlengang
   - Ringfeld geeignet für Scanning-Betrieb,
   - obskurationsfreier Lichtführung,

   **gekennzeichnet durch**

   - einen konvexen Primärspiegel (M1),
   - positive Hauptstrahlwinkelvergrößerung des Sekundärspiegels (M2).

2. Reduktionsobjektiv nach Anspruch 1, **dadurch gekennzeichnet, dass** die vier Spiegel (M1, M2, M3, M4) in zentrierter Anordnung bezüglich einer optischen Achse Multilayer-Spiegel sind.

3. Reduktionsobjektiv nach Anspruch 1 oder 2, **dadurch gekennzeichnet, dass** eine Blende (B) auf oder nahe einem Spiegel liegt, insbesondere dem Tertiärspiegel (M3).

4. Reduktionsobjektiv nach mindestens einem der Ansprüche 1 bis 3, **dadurch gekennzeichnet, dass** zusätzlich ein oder zwei Spiegel (GIM) in streifendem Einfall angeordnet sind.

5. Reduktionsobjektiv nach Anspruch 4, **dadurch gekennzeichnet, dass** der oder die zusätzlichen Spiegel (GIM) von einer Planfläche abgeleitete asphärische Flächen aufweisen

6. Reduktionsobjektiv nach Anspruch 4 oder 5, **dadurch gekennzeichnet, dass** mindestens ein Spiegel (GIM) ein aktiver Spiegel ist.

7. Reduktionsobjektiv nach mindestens einem der Ansprüche 1 bis 6, **dadurch gekennzeichnet, dass** der Sekundärspiegel (M2) und der Quartärspiegel (M4) konkav sind.

8. Reduktionsobjektiv nach mindestens einem der Ansprüche 1 bis 7, **dadurch gekennzeichnet, dass** die Multilayer-Spiegel (M1, M2, M3, M4) in der Reihenfolge konvex-konkav-konvex-konkav ausgebildet sind.

9. Reduktionsobjektiv nach mindestens einem der Ansprüche 1 bis 8, **dadurch gekennzeichnet, dass** es objektseitig telezentrisch ist.

10. Reduktionsobjektiv nach mindestens einem der Ansprüche 1 bis 9, **dadurch gekennzeichnet, dass** der Hauptstrahl (CR) am Objekt (2) von der optischen Achse (HA) weg läuft.

11. Reduktionsobjektiv nach mindestens einem der Ansprüche 1 bis 10, **dadurch gekennzeichnet, dass** es bildseitig telezentrisch ist.

12. Projektionsbelichtungsanlage mit einem Reduktionsobjektiv nach mindestens einem der Ansprüche 1 bis 11, **dadurch gekennzeichnet, dass** eine Reflexionsmaske vorgesehen ist.

13. Projektionsbelichtungsanlage mit einem Reduktionsobjektiv nach mindestens einem der Ansprüche 1 bis 11, **dadurch gekennzeichnet, dass** eine Transmissionsmaske vorgesehen ist.

14. Verfahren für Chipherstellung mit einer Projektionsbelichtungsanlage gemäß einem der Ansprüche 12 oder 13.

**Claims**

1. Reduction objective, especially for EUV-microlithography, with

   - four mirrors (M1, M2, M3, M4) in centered arrangement with respect to an optical axis, with a primary, a secondary, a tertiary, a quaternary mirror in this sequence arranged in the optical path with

- a ring field suitable for scanning operation, an obscuration free light guiding,

  **characterized in that**,

- a convex primary mirror (M1),
- a positive chief ray angular magnification of the secondary mirror (M2) is provided.

**2.** Reduction objective according to claim 1, **characterized in that**,
the four mirrors (M1, M2, M3, M4) in centered arrangement with respect to the optical axis are multilayers.

**3.** Reduction objective according to claim 1 or 2, **characterized in that**,
a diaphragm (B) on or near a mirror is situated, especially on the tertiary mirror (M3).

**4.** Reduction objective according to at least one of the claims 1 to 3,
**characterized in that**,
furthermore one or two mirrors are disposed at gracing incidence.

**5.** Reduction objective according to claim 4, **characterized in that**,
the further mirror (GIM) comprises an aspherical surface derived from a plane surface.

**6.** Reduction objective according to claim 4 or 5, **characterized in that**,
at least one mirror (GIM) is an active mirror.

**7.** Reduction objective according to at least one of the claims 1 to 6,
**characterized in that**,
the secondary mirror (M2) and the quaternary mirror (M4) are concave.

**8.** Reduction objective according to at least one of the claims 1 to 7,
**characterized in that**,
the multilayer mirror (M1, M2, M3, M4) are shaped in a convex-concave-convex-concave sequence.

**9.** Reduction objective according to at least one of the claims 1 to 8,
**characterized in that**,
the objective is telecentric on the object side.

**10.** Reduction objective according to at least one of the claims 1 to 9,
**characterized in that**,
the chief ray of the object is directed away from the optic axis.

**11.** Reduction objective according to at least one of the claims 1 to 10,
**characterized in that**,
the reduction objective is telecentric on the image side.

**12.** Projection exposure apparatus with a reduction objective according to at least one of the claims 1 to 11, **characterized in that**,
the mask is a reflection mask.

**13.** Projection exposure apparatus with a reduction objective according to one of the claim 1 to 11, **characterized in that**,
the mask is a transmission mask.

**14.** A method for integrated circuit fabrication using a projection apparatus according to claim 12 or 13.

**Revendications**

**1.** Objectif de réduction, particulièrement d'EUV microlithographique comportant

- des quatre miroirs (M1, M2, M3, M4) en arrangement centré relatif à un axe optique, avec un miroir primaire, un miroir secondaire, un miroir tertiaire, un miroir quaternaire, en cet ordre dans la trajectoire des rayons
- un champ annulaire susceptible à une opération de scanner
- un guidage de lumière exempte d'obscurcissement
- **caractérisé par**
- un miroir primaire (M1) convexe
- un positif angle d'agrandissement de rayon principal du miroir secondaire (M2).

2. Objectif de réduction selon la revendication 1, **caractérisé en ce que** les quatre miroirs (M1, M2, M3, M4) en arrangement centré relatif à un axe optique sont des miroirs avec des couches plusieurs.

3. Objectif de réduction selon la revendication 1 ou 2, **caractérisé en ce qu'**un diaphragme (B) est situé sur ou prés d'un miroir, particulièrement du miroir tertiaire (M3).

4. Objectif de réduction au moins selon la revendication 1 à 3, **caractérisé en ce qu'**un ou deux miroirs (GIM) sont arrangés supplémentaire en incidente rasante.

5. Objectif de réduction selon la revendication 4, **caractérisé en ce que** le ou les miroirs (GIM) supplémentaire comportent des faces asphériques derivées d'une face plane.

6. Objectif de réduction selon la revendication 4 ou 5, **caractérisé en ce que** au moins un miroir (GIM) est un miroir actif.

7. Objectif de réduction au moins selon l'une des revendications 1 à 6, **caracterisé en ce que** le miroir secondaire (M2) et le miroir quaternaire (M4) sont concaves.

8. Objectif de réduction au moins selon l'une des revendications 1 à 7, **caractérisé en ce que** les miroirs avec des couches plusieurs (M1, M2, M3, M4) sont formés avec la séquence convexe-concave-convexe-concave.

9. Objectif de réduction au moins selon l'une des revendications 1 à 8, **caractérisé en ce qu'**il est télécentrique côté objet.

10. Objectif de réduction au moins selon l'une des revendications 1 à 9, **caractérisé en ce que** le rayon principal (CR) enfuit, sur l'objet (2), en direction de l'axe optique (HA).

11. Objectif de réduction au moins selon l'une des revendications 1 à 10, **caractérisé en ce qu'**il est télécentrique côté image.

12. Installation d'illumination par projection équipée d'un objectif de réduction au moins selon l'une des revendications 1 à 11, **caractérisé en ce qu'**il est prévu un masque de réflexion.

13. Installation d'illumination par projection équipée d'un objectif de réduction au moins selon l'une des revendications 1 à 11, **caractérisé en ce qu'**il est prévu un masque de transmission.

14. Procédé de fabrication de puces à l'aide d'une installation d'illumination par projection selon l'une des revendications 12 ou 13.

FIG. 1

FIG.2

STAND der TECHNIK

typ_e(92) 4x/0.1 1.5mm Ringfield    Scale: 0.12    ORA   11-Mar-90

200.00  MM

FIG.3

M2

2

CR

M1

HA

4

M3

M4

200.00 MM

Typ_f(94) 4x/0.10      1.0mm Ringfield      Scale:    0.12    ORA   16-Apr-98

FIG.4

Typ_g(68)  4x/0.10 1.25mm Ringfield     Scale:   0.12   ORA  16-Apr-98

EP 1 480 082 B1

FIG.5

GIM

H1

H4

H3

M2

2

4

200.00 MM

Typ_f(92) 4x/0.10      1.5mm ringfield      Scale:  0.12   ORA  16-Apr-98

EP 1 480 082 B1